# EUROPEAN PATENT APPLICATION

(11) **EP 2 354 801 A1**
(43) Date of publication of application: **10.08.2011**
(21) Application number: 10003259.8
(22) Date of filing: 26.03.2010
(51) Int. Cl.: G01R 29/08

(54) **Holding device and system for positioning a device for a wireless communication in a measurement environment**

(30) Priority: 03.02.2010 EP 10001119
(71) Applicant: Rohde & Schwarz GmbH & Co. KG, 81671 München (DE)
(72) Inventor: Tankielun, Adam, Dr., 85521 Ottobrunn (DE); Boehler, Erwin, 81737 München (DE)
(74) Representative: Beder, Jens

(57) **Abstract**

System for positioning a device for wireless communication in a measurement environment, the system comprises a holding device (2) and a support structure (3) for positioning the holding device (2). The holding device (2) comprises a holding means (4) for holding the device for wireless communication. The outer surface of the holding device (2) surrounds or mostly surrounds the holding means (4) .

## Description

The invention relates to a holding device and system for positioning a device for wireless communication in a measurement environment. Especially, the invention relates to the positioning of the device for wireless communication in different orientations for an orientation-dependent "over the air" (OTA) measurement of transmitting and receiving characteristics of the wireless communication device.

The transmitting or receiving characteristics of wireless communication devices are measured in dependence of transmitting or receiving angle of the electromagnetic wave with respect to the wireless communication device in OTA performance testing. Therefore, the wireless communication device under test is positioned in an anechoic environment by means of a positioning device. The positioning device comprises usually a table pivotable in the plane of the table. A rod is mounted on the pivotable table in the direction orthogonal to the rotation plane of the table. The rod comprises on the opposite side of the table a holding means on which the wireless communication device is put for measurement. The holding means of the wireless communication device is mounted on the rod in such that it can rotate together with the held wireless communication device around an axis of rotation being orthogonal to the axis of rotation of the pivotable table. Consequently, by the rotation of the table and the holding means of the wireless communication device, the wireless communication device can be positioned in every orientation in a three-dimensional space. The anechoic environment comprises also at least one fixed test antenna in a certain distance of the wireless communication device to measure characteristics of the wireless communication device in dependence of an angular orientation of the wireless communication device under test relative to the fixed antenna(s).

The problem of the state of the art is that the electromagnetic radiation of the wireless communication device or the testing antenna is reflected by the positioning structure of the wireless communication device. In addition, in some orientations of the wireless communication device the radiation between the wireless communication device and the measurement antenna has to pass through the rod or the fixation of the wireless communication device. Despite of the use of materials with low relative permittivities there is an impact of the positioning structure of the wireless communication device on the measurements results.

DE 600 15 981 T2 proposes to place the device for wireless communication on a pivotable table and arrange a number of test antennas or sensors on a semi-circle around the pivotable table. This has the advantage that the positioning device has to be pivotable only around one axis of rotation and reflections at the rod and the second rotation mechanism are omitted. However, reflections still occur on the pivotable table and the electromagnetic waves from some test antennas or sensors have to pass through the pivotable table to reach the device for wireless communication while others have not to pass the pivotable table. This badly affects the test results. In addition, such a measurement environment needs a lot of space.

The object of the invention is to find a holding device and a system for positioning a wireless communication device in a testing chamber which overcomes the problems of the state of the art. It is a special object of the invention to reduce the disturbances by reflections of the positioning structure on the measurement results.

The object of the invention is solved by the holding device according to claim 1. The holding device according to the invention is suitable for positioning a device for wireless communication in a measurement environment e.g. a testing chamber. The holding device comprises holding means for holding the device for wireless communication. According to the invention, the holding device is formed such that its outer surface surrounds or mostly surrounds the holding means.

The invention is also solved by the system according to claim 16. The system according to the invention is suitable for positioning a device for wireless communication in a measurement environment. The system comprises the described holding device and a support structure for positioning the holding device in the measurement environment. The holding device is positionable in the support structure at different orientations, preferably at every angle around at least one axis of rotation.

The holding device according to the invention has the advantage that the radiation between the measurement antenna and the wireless communication device has to pass through the holding device to reach the device for a wireless communication for all or nearly all orientations. Therefore, the disturbances created by the holding device are independent from the orientation of the device for a wireless communication, because the electromagnetic wave has to pass the holding device at every orientation of the wireless communication device. The holding device has further the advantage that the wireless communication device is rotated together with the holding device which overcomes the problem of complicated rotation mechanisms causing reflections.

The dependent claims refer to further advantageous embodiments of the invention.

It is especially advantageous that for at least one axis of rotation of the holding device every axis being orthogonal to said axis of rotation is orthogonal or mostly orthogonal to the outer surface of the holding device. Consequently, at every angle of rotation of the wireless communication device under rotation around said axis of rotation, the electromagnetic wave between the test antenna and the wireless communication device enters the outer surface of the holding device at least approximately orthogonally. This causes minimum reflections of the electromagnetic wave.

In a preferred embodiment, the holding means is positioned in the center of the holding device. By centering the holding means in the holding device, a device for wireless communication positioned on the holding means is positioned centrally in the holding device such that the electromagnetic wave between the test antenna and the wireless communication device has to pass under every orientation the same length or almost the same length through the holding device. This is especially advantageous in combination with a holding device which is rotation-symmetric or almost rotation-symmetric.

In a preferred embodiment, the holding means is realized by a recess in the holding device, e. g. by a recess in the sphere. The recess has the advantage that it is very simple and does not need any mechanical parts which causes further disturbances by reflections. The wireless communication device can be attached to a surface in the recess by a double sided adhesive tape. To guarantee that the holding means is arranged centrally in the holding device, the recess should pass through the center point of the holding device, e. g. through the center point of the spherical shape of the holding device. In a further preferred embodiment, the holding means comprises a cartridge being insertable in the recess. Consequently, the cartridge can hold wireless communication devices of different sizes centrally in the recess, e.g. by using different cartridges for different classes of size. Different classes of size occur for example in testing wireless local area network antennas of mobile computers and testing mobile phones. It is especially advantageous for the insertion of the cartridge, if the recess is accessible from the outer surface of the holding device. This allows a very simple mounting procedure and in addition, the cartridge can close the opening of the recess in the outer surface of the holding device and further reduce the influence on the OTA measurement results.

In a preferred embodiment of the invention the holding device has a relative permittivity less than 4, in particular lower than 2, in particular lower than 1.2. Such an overall low relative permittivity of the holding device reduces the disturbing effect of the holding device.

In a preferred embodiment of the invention, the holding device has a spherical shape. Consequently, the electromagnetic wave between the test antenna and the wireless communication device passes the outer surface of the holding device in every orientation of the holding device with an angle of 90°. This is especially advantageous in combination with the central orientation of the holding means in the holding device.

In a preferred embodiment, the holding means is suitable for holding the device for wireless communication together with a simulating device for simulating at least a part of a human body like a simulated human head and/or a simulated human hand. In an alternative embodiment, the holding means has inhomogeneous relative permittivity simulating at least a part of a human body. Both embodiments have the advantage to permit the testing of influences of the human body during the OTA performance testing. The second embodiment is advantageous, because the holding means has not to be designed as to hold a wireless communication device together with a simulated human head or other part of the body. The holding means can be designed in the size of the device under test and the simulation of the part of the human body can be realized by using different holding devices simulating different parts and/or positions of the human body or another holding device for an OTA performance testing without any human body influences. The part of the human body can even be simulated by a cartridge.

In a preferred embodiment, the support structure of the system according to the invention comprises an opening, e.g. a through hole in a table, which is of circular shape with a diameter being smaller than the diameter of the spherical holding device. As a consequence, the spherical holding device can be positioned in every orientation within the circular opening. Both, support structure and holding device, are designed simple without any edges of complicated rotation mechanisms which would cause distortions by reflections of the radiation.

In a preferred embodiment of the invention, the holding device comprises two hemispherical parts or two nearly hemispherical parts which form together the spherical holding device. Preferably, the two hemispherical parts divide the holding device such that the plane of separation of the two hemispherical parts pass the recess in a plane being parallel to the longitudinal axis of the recess. The recess is well accessible by disassembling the two hemispherical parts and the wireless communication device can be fixed in the recess to the holding means. Therefore, the user can easily divide the holding device and fix the wireless communication device in the recess and put the hemispherical parts together such that the holding device encloses the wireless communication device.

Preferably, the two hemispherical or nearly hemispherical parts can be fixed to each other by a form-locked joint in only one way such that the two hemispherical or nearly hemispherical parts together form a sphere. Consequently, a user can fix the two hemispherical parts in only one correct way. In addition, it is advantageous, that the form-locked joint is only openable by sliding one hemispherical part along the other hemispherical part. Thus, a slidable movement of the two hemispherical parts in the sliding direction is further hindered by placing the connected two hemispherical parts in the opening of the support structure, i.e. here by the edge of the opening of the support structure.

In a preferred embodiment the spherical holding device shows a number of first type circle lines on the outer surface which all intersect in two opposing points. Preferably, these circle lines are marked with the corresponding azimuth angles of the sphere. The edge of the opening of the support structure shows a mark, e.g. a radial line with respect of the centre point of the circular opening. Thus, in almost every orientation of the holding device, the azimuth angle of orientation of the holding device, i.e. of the wireless communication device, can be read immediately by any user. Preferably, the spherical holding device comprises a second type of circle lines being parallel to each other. In the case the first and second type of circle lines are signed on the spherical holding device, the second type circle lines are orthogonal to the first type circle lines in each intersection point. Preferably, the polar angles, e.g. from 0 to 180°, are marked at the second type circle lines, preferably along a first type circle line. The point on the holding device, where the polar angle starts with 0° is defined at the place, where all the first type circle lines intersect, preferably at the top side of the holding device. Consequently, the other point, where all the first type circle lines intersect at the bottom side refers to a polar angle of 180°. Preferably, the polar angles are marked with an off-set at the second type circle lines such that the actual holder angle of the holding device according to coordinate system can be read at the mark at the boarder of the opening of the support structure. That means that the polar angle is marked on the circle line with an offset. Thus, when the top intersecting point referring to a polar angle of 0° points straightly to the top, the second type circle line at the boarder of the opening at the mark marks 0°. As a consequence every user, not necessarily skilled in the art, can rotate the holding device in the opening of the support structure and simply read the azimuth angle and the polar angle at the mark at the opening of the support structure.

In another preferred embodiment, the holding device has a cylindrical shape. It is further advantageous that the holding device comprises a first rotation element having a cylindrical shape and a second rotation element with said holding means being positionable in the first rotating element in at least two positions, whereby in the at least two positions, the holding means has a different angle with the cylinder axis of the first rotation element. This embodiment allows to access and see the equipment under test in a simple manner.

In a preferred embodiment, the holding device is positioned pivotally on the support structure. In further preferred embodiment, the support structure comprises driving means for automated rotation of the holding device at least around one axis of rotation. Consequently, the orientation of the holding device has not to be changed manually and the time for the testing process can be reduced. A driving means for the spherical holding means could be realized by a support structure comprising three balls arranged on a circle. The holding means is supported by the three balls. A first and a second ball are suitable for driving the holding device around a first and a second axis of rotation respectively, wherein the first and second axis of rotation is preferably orthogonally to each other, in particular one is orthogonal on the circle plane. The balls are arranged nearly at an angle of 90° to the centre point of the circle. The third ball is pivotable and is arranged between an angle of 90° to 180° of each of the two balls with respect to the centre point of the circle such that the three balls form a stable support for the holding device. The arrangement of the driving balls at 90° allows minimum friction of one driving ball during rotation of the respective other.

It is further advantageous that the system comprises orientation detection means for automatic detection of the actual position of the holding device with respect to the support structure. Especially, in combination with an automatic rotation of the holding device with respect to the support structure, the OTA performance testing can be completely automated.

When in this application it is mentioned that the holding means is surrounded by the outer surface of the holding device that means that the holding means is fully enclosed by the holding device, in particular by the outer shell of the holding device. As a consequence, an electromagnetic wave transmitted from the device for wireless communication has to pass the outer shell of the holding device to be received at the test antenna and vice versa. When in this application is mentioned that the holding means is mostly surrounded by the outer surface of the holding device that means that the outer shell of the holding device surrounds the holding means except for an area of the surface cause by a recess for forming the holding means.

Two preferred embodiments will be explained with the help of the drawing. The drawing shows:
- Fig. 1: a three-dimensional view of a first embodiment of the system according to the invention for positioning a device for a wireless communication;
- Fig. 2: a cross-sectional view of the first embodiment;
- Fig. 3: a support table and first hemispherical part of the holding device according to the first embodiment;
- Fig. 4: the support table and a second hemispherical part of the holding device according to the first embodiment;
- Fig. 5: a three-dimensional view of a first rotation element according to a second embodiment of invention for positioning a device for a wireless communication; and
- Fig. 6: a three-dimensional view of a second rotation element according to a second embodiment of invention for positioning a device for a wireless communication.

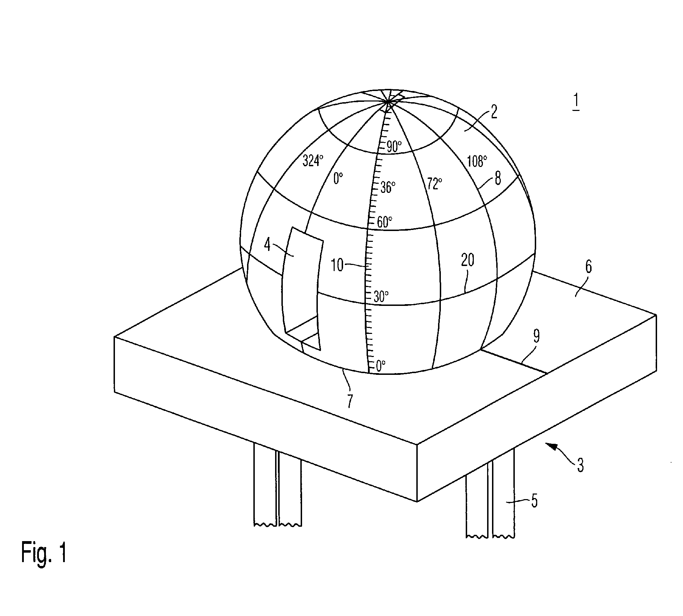

Fig. 1 to 4 show a first embodiment of the system for positioning a wireless communication device in a measurement environment according to the invention. The wireless communication device may be any electronic apparatus which is capable of establishing a wireless communication link to a second device. In a preferred use of the invention it will be a mobile telephone. Fig. 1 shows the system 1 which comprises a holding device 2 and a support table 3 as supporting structure. The system 1 is normally placed in an anechoic chamber which is shielded against disturbing radiations from outside. The anechoic chamber comprises also at least one fixed test antenna for measuring the transmitting and receiving characteristics of the wireless communication device in dependence of its orientation adjusted by the system 1. The device for wireless communication under test is here a mobile phone. However, the invention is not restricted to mobile phones as entity under test (EUT) but is suitable for every kind of device for a wireless communication such as every device communicating by mobile phone standards like Global System for Mobile Communication (GSM), General Package Radio Service (GPRS), Universal Mobil Telecommunication Systems (UMTS), Long Term Evolution (LTE) etc., every device communicating with wireless local area network (WLAN) such as Notebooks, devices communicating with worldwide interoperability for microwave access (WIMAX), devices communicating with Bluetooth or even broadcasting systems.

The holding device 2 according to the first embodiment has an exact spherical outer shape. The holding device 2 is manufactured solidly with a radio frequency transparent or nearly radio frequency transparent material. Such materials have relative permittivities *∈*ᵣ next to 1. There are even new materials with an *∈*ᵣ lower than 1. The holding device 2 has a recess 4 from one side of the holding device to the opposing side along a straight line through the center point of the spherical holding device 2. In this embodiment, the longitudinal axis of the recess 4 is equal to a straight line through the centre point of the spherical holding device 2. The recess 4 has a rectangular cross-sectional shape. The dimension of the recess 4 depends on the entity under test (EUT), here a mobile phone. The diameter of the holding device 2 approximately corresponds to the length of the DUT.

The support table 3 as support structure comprises a planar board 6 and legs 5. The planar board 6 has a circular cutout 7 as opening which is arranged centrally in the planar board 6. The cutout 7 is arranged on the side of the board 6 which has a larger surface than the other sides. In this embodiment, the cutout 7 is formed by a through hole in the support table 3. The cutout 7 is suitable for carrying the holding device 2 and holding the holding device 2 in a certain orientation. The diameter of the circular cutout 7 is smaller than the diameter of the spherical holding device 2. Preferably, the diameter of the circular cutout 7 is larger than 20 %, preferably larger than 30 %, more preferably approximately 40 % of the diameter of the sphere of the holding device 2.

To further reduce the reflections of the support table 3, the edges of the support table 3 could be rounded or cut at an angle other than 90°. In an alternative embodiment, a support structure with a nearly spherical shape or a shape being optimized for minimal reflections from the test antenna could be used, wherein the spherical shape shows tangential flattening on one side for placing the support structure in the anechoic chamber. On the other side of the flattening, the support structure could show an opening for the holding device 2 which has a circular border line, whereon the holding device 2 is seated solidly.

In order to measure the actual orientation of the holding device 2, i.e. of the held wireless communication device, in a spherical coordinate system of the support table 3, a spherical coordinate system is indicated on the holding device 2. The signed spherical coordinate system comprises a number of principal first circle-lines 8 as first type circle-lines on the spherical holding device 2 which all intersect in two opposing points. Five exemplary principal first circle lines 8 are marked on the holding device 2 according to the embodiment of the invention. At every principal half-circle-line 8 between two intersecting points the corresponding azimuth angle is marked. Preferably, there are marked additional secondary first circle-lines as additional first type circle lines (not shown in Fig. 1) between two principal first circle-lines 8 for measuring the azimuth angle more exactly. Certainly, the secondary first circle-lines intersect in the same two opposing points as the principal first circle-lines. The secondary first circle-lines could be marked on the holding device 2, for example at every five degrees. The secondary first circle-lines can be marked in a different colour than the ten principal first circle-lines 8. The number of ten principal first circle-lines 8 has been chosen arbitrarily. The number of principal first circle-lines could be adapted to a number which causes round azimuth angles like with eight, twelve, twenty-four or thirty-six principal first circle lines. The support table 3 comprises at the upper side of the board 6 which points versus the holding device 2 a mark 9 at the boarder of the cutout 7. Consequently, in almost every orientation of the holding device 2, the actual azimuth angle of the holding device 2 can be measured by picking out the principal or the secondary first circle-line being closest to the mark 9 at the border of the cutout 7.

In order to measure the polar angle of the spherical coordinate system of the holding device 2, there are a number of principal second circle-lines 20 as secondary type circle-lines, which are intersect every first circle line orthogonally. The principal second circle lines 20 are arranged parallel to each other and are arranged preferably equidistant. The corresponding polar angles of the spherical coordinate system of the holding system 1 are marked at the principal second circle lines 20. In addition, a scale 10 is signed along one of the principal first circle-lines 8 for reading the polar angle of the spherical coordinate system more detailed. The scale 10 could also be marked along any one of the secondary circle-lines or another circle-line intersecting with said opposing intersection points, wherein the other circle-line has not necessarily be marked on the holding device 2. The scale 10 is preferably linear and comprises equidistant marks for the polar angles. In an alternative embodiment, the marks of the scale 10 can be realized as secondary second circle-lines as additional second type circle-lines being parallel to the principal and/or secondary first circle-lines 20. The polar angle of the holding device 2 can be measured by reading the marked polar angle of the second circle line intersecting the border of the cut-out 7 being closest to the mark 9. The polar angles are marked such at the second circle-lines or the scale 10 that the actual polar angle of the holding device 2 according to the chosen spherical coordinate system can be read at the boarder of the cutout 7 at the mark 9, i.e. with an offset.

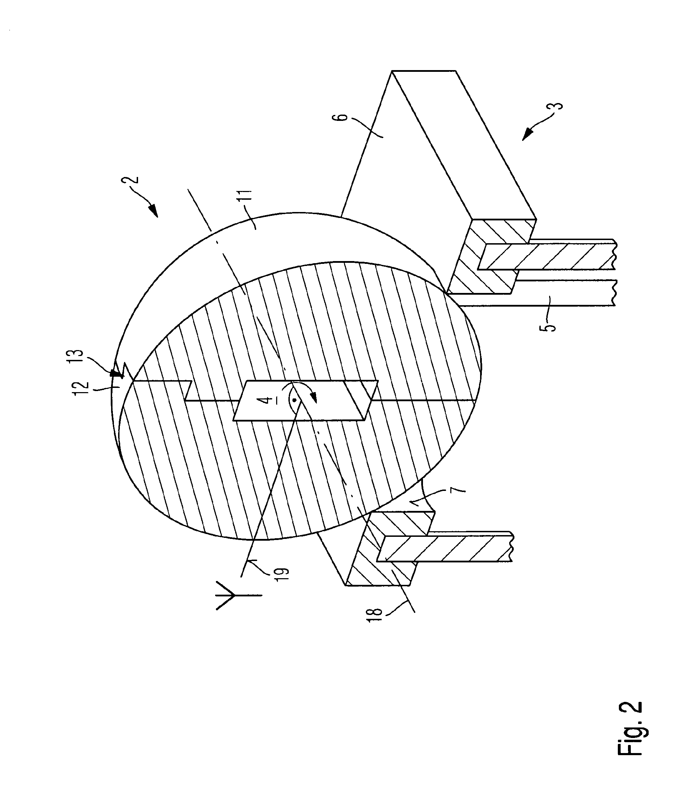

In this embodiment, the spherical coordinate system is chosen such that the azimuth angle 0° starts at one of the principal half-circle-lines passing through the recess 4, preferably through the symmetry axis of the recess 4. The polar angle 0° is at one of the points where all first-circle lines intersect. In particular, at the top one of these two points. Consequently, the polar angle at the bottom point is 180°. The coordinate system is determined by the standard of testing of the corresponding EUT, here a mobile phone. Certainly, the mobile phone has to be placed accordingly in the recess 4. In figures 2, 3 and 4, the lines on the outer surface of the holding device 2 for measuring the azimuth and polar angle are not shown anymore.

Fig. 2 shows a cross-sectional view through the holding device 2 and the support table 3. Fig. 2 shows that the holding device 2 comprises two hemispherical parts 11 and 12 which form together the sphere of the holding device and are held together by a dovetail joint 13.

A rotational axis 18 is indicated by a dotted line falling on the symmetry axis of the recess forming the holding means. Line 19 indicates an axis being orthogonal to the axis of rotation 18. As it can easily be seen, this orthogonal axis 19 also indicating direction of propagation of electromagnetic radiation emitted from an antenna intersects the surface of the holding device 2 at an angle of 90°. For only one axis of rotation 18, this is also fulfilled by a cylindrical holding device.

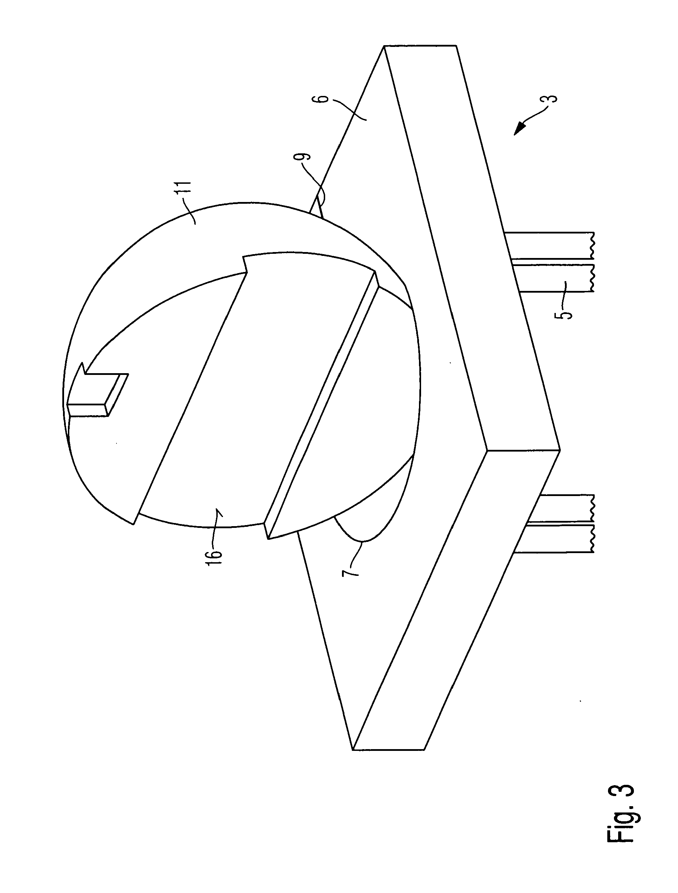

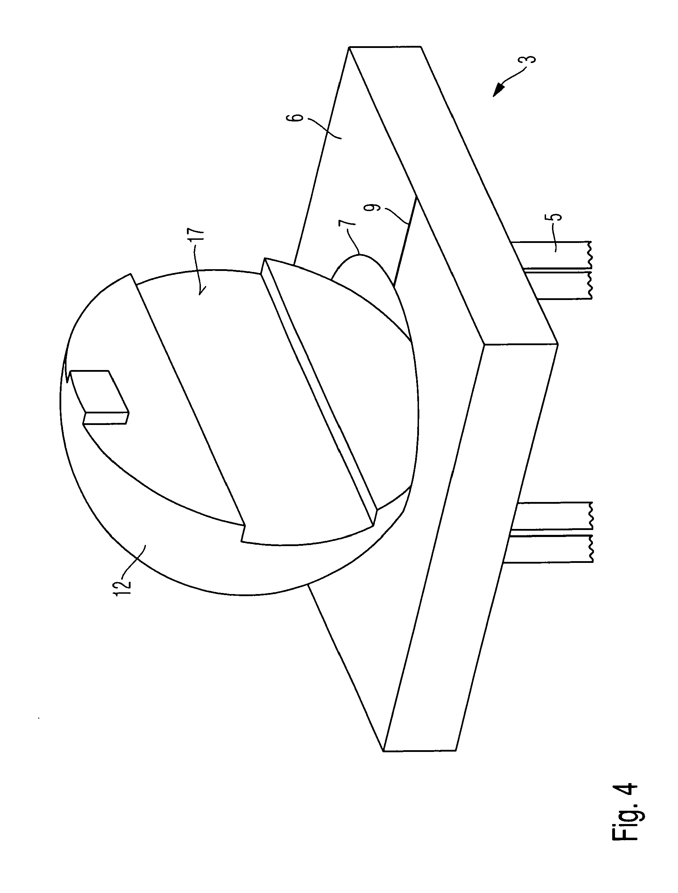

Fig. 3 and 4 show a three-dimensional view of the support table 3 with the first or second hemispherical part 11 and 12 of the holding device 2 respectively placed in the cutout 7. The holding device 2 is divided such in two hemispherical parts 11 and 12 that the dividing surface passes the recess 4 and passes the centre point of the spherical holding device 2. This allows to easily access the recess 4 and to fix the mobile phone in the recess 4 by separating the two hemispherical parts 11 and 12. Preferably, the mobile phone is fixed in the recess 4 by a tape or other adhesive means. When the mobile phone is fixed in the recess 4, the second hemispherical part 12 of the holding device 2 can be joined via the dovetail joint 13 with the first hemispherical part 11. In order to join the first hemispherical part, a tale 14 is cut into the hemispherical part 11. A pin 15 sticks out of the surface of the second hemispherical part 12 which is in contact with the first hemispherical part 11. The pin 15 is shaped correspondingly to the tale 14 cut out of the first hemispherical part 11. The second hemispherical part 12 can be fixed to the first hemispherical part 11 by sliding the pin 15 in the tale 14 in the direction to the center point of the hemispherical point 11. Each hemispherical part 11 and 12 show a partial recess 16 and 17, respectively, which form together the recess 4, when the two hemispherical parts 11 and 12 are joined to the holding device 2. By placing the two hemispherical parts in the cutout 7 as shown in fig. 2 the two hemispherical parts 11 and 12 are forced to form a spherical shape of the holding device 2. The dovetail joint 13 prevents rotation of the two hemispherical parts versus each other and unintended separation in the cutout 7.

In an alternative embodiment the recess 4 could have a different shape such as a cylinder or a sphere. However, the rectangular form is especially advantageous, because it allows the fixing of the mobile phone by a tape at one of the planar side walls of the recess 4. In one embodiment, the recess could be shorter than the diameter of the holding device 2. Consequently, the electromagnetic wave between the mobile phone and the measurement antenna has to pass always through the outer surface of the holding device. The recess would be only accessible by dividing the two hemispherical parts 11 and 12. In another embodiment, the open ends of the recess 4 could be closed by a closing means manufactured with the same material as the holding device 2 to achieve that propagating electromagnetic waves have always to pass through the outer surface of the holding device 2.

In another embodiment the mobile phone can be placed in a cartridge. The outer shape of the cartridge has a shape corresponding to the chosen form of the recess 4. Consequently, the mobile phone could be inserted in the holding device 2 by placing the cartridge in the recess 4. This would have the advantage that for different mobile phones with different dimensions, different cartridges can be used. As a consequence, the mobile phone would always be positioned well in a center of the spherical holding device even if large and small EUTs are tested such as mobile phones and notebooks. In addition, the holding device could be manufactured out of one piece and the separation for fixing the mobile phone in the recess is not necessary any more. This further reduces the reflections caused by the border surfaces between the two hemispherical parts.

In another embodiment of the invention the spherical holding device comprises two nearly spherical parts forming together a sphere. However, the holding device is not dividable by the surface passing the centre point of the spherical holding device and of the recess but through the surface passing along one of the sidewalls of the recess. This has the advantage that the recess is formed only in one of the two parts and the mobile phone can fill out the full recess 4 without disturbing the slidability of one nearly hemispherical part over the other nearly hemispherical part.

In all described embodiments of the invention, the holding device has a spherical shape. This has-the advantage that the electromagnetic wave between the mobile phone and the measurement antenna passes the outer surface of the holding device under an angle of 90° if the EUT is arranged at the centre point of the holding device or nearly 90° angle if the antenna of EUT is not exactly arranged centrally in the holding device. This causes minimum reflections of the electromagnetic wave. However, the invention is not restricted to a spherical shape.

In an alternative simplified embodiment, the holding device can be a cylinder enclosing the EUT. The cylinder comprises preferably a recess along the cylinder axis of the cylinder like in a hollow cylinder. The cross-section of the recess is preferably a circle to cause minimum reflections. However, the cross-section of the recess can even be rectangular, quadratic or any other polyangular. The electromagnetic wave between the test antenna and the mobile phone being oriented orthogonal to the axis of the cylinder is always orthogonal to the outer surface of the cylinder for every state of rotation of the cylinder with the mobile phone around the rotation axis of the cylinder, i.e. the cylinder axis. This embodiment is advantageous for measurements of the radiation characteristic of a mobile phone in two dimensions. This embodiment can be combined with any of the described holding means of the spherical holding device. The support table holding the cylindrical holding device can be rotated all together or only the table plane could be bear pivotably around an axis being rectangular to the axis of rotation of the cylinder. Such every orientation of the cylindrical holding device could be achieved. This could be especially advantageous when the cylindrical holding device is rotated electrically and / or the rotation of the table is achieved automatically by an electric motor.

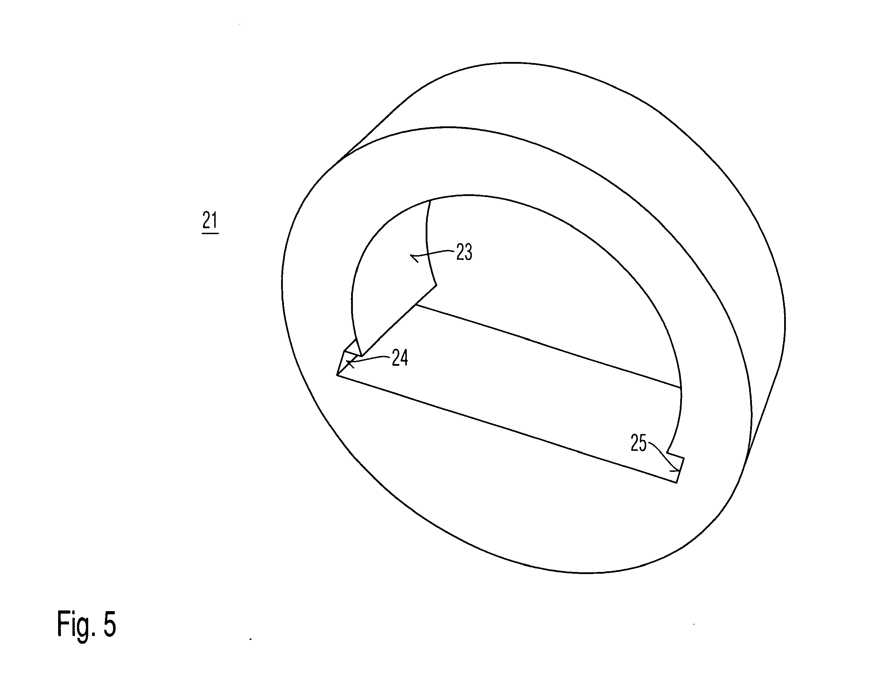

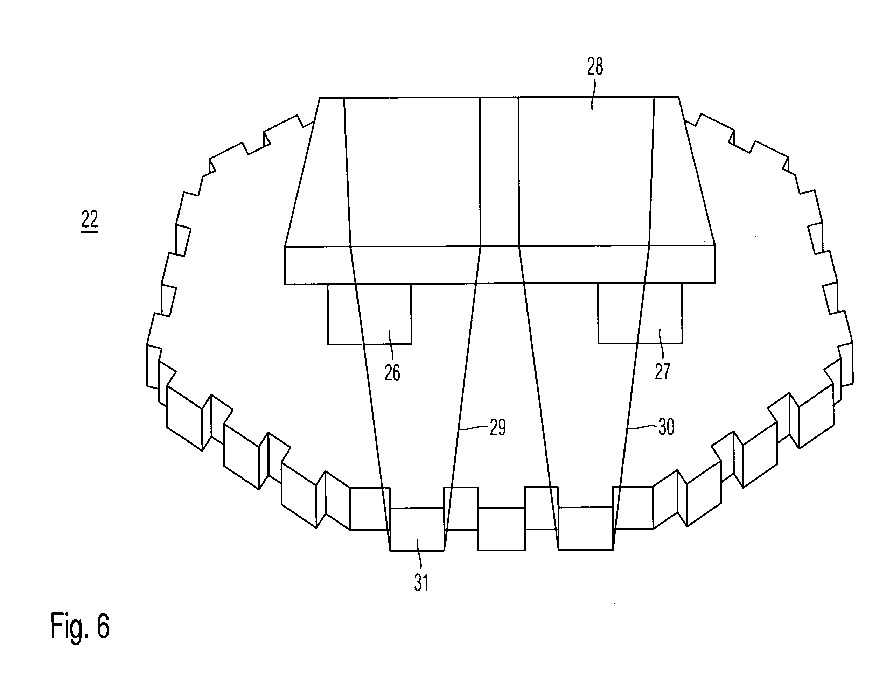

Fig. 5 and 6 show a holding device according to a second embodiment of the invention with first rotation element 21 shown in Fig. 5 and a second rotation element 22 shown in Fig. 6.

Fig. 5 shows the first rotation element 21 suitable for positioning of the first rotation element 21 in every polar angle from 0° to 180°. The first rotation element 21 has a recess 23 from one side of the cylinder to the other cylinder side along the cylinder axis. The cross-section of the recess 23 has roughly the form of a semi-circle. Fixing recesses 24 and 25 are formed in the curved side walls of the recess 23 in the corners between the flat side and the curved side of the recess 23. The fixing recesses 24 and 25 have a rectangular shape 24 each.

Fig. 6 shows the second rotation element 22 suitable for being positioned in eight positions with respect to the first rotation element 21. The second rotation element 22 is shaped as a plate. The plate is shaped as a symmetric octagon with equal sides and angles. Teeth 30 are arranged around the thin side of the plate-shaped second rotation element 22 similar to a toothed wheel. Here each side of the octagon shows three teeth 30. The thickness of the plate and of the teeth correspond to the thickness of the fixing recesses 24 and 25 and the distance between teeth 31 of two opposing sides of the second rotation element 22 corresponds to the distance of the side walls of the fixing recesses 24 and 25. The second rotation element 22 is at least partly insertable in eight positions in the fixing recesses 24 and 25 within the recess 23. Consequently, eight equidistant azimuth angles of second rotation element 22 can be realized without any rotation or repositioning of the first rotation element 21.

The second rotation element 22 has two blocks 26 and 27 for positioning a mobile phone 28 as device or entity under test. The mobile phone 28 is fixed by two elastic endless bands 29 and 30. Each elastic endless band 29 and 30 can be fixed to the second rotation element 22 by two opposing or nearly opposing teeth 31 by leading the endless bands 29 and 30 around the side of the teeth 31 being-opposed to the side holding the mobile phone 28. The holding means of the second embodiment comprises blocks 26 and 27, the teeth 31 and the elastic endless bands 29 and 30.

Instead of an octagonal plate, even a rectangular, hexagonal, any other even-numbered, any odd-numbered or circular shaped plate can be used for positioning the second rotation element in four, six, any other even number of, an odd number of or infinite positions in the fixing recesses 24 and 25. In the case of a circular shaped second rotation element 22, the second rotation element 22 could be centrally fixed by a pin such that the second rotation element 22 could be rotated around the pin. The pin should be made out of the same material as the holding device. Alternatively, the fixing recesses could be formed also in the circular shape of the circular contour of the second rotation element 22. Consequently, the second rotation element would be fixed within the fixing recesses, but would be pivotally within the fixing recesses. The teeth could even be arranged on the side of the second rotation element 22 holding the mobile phone 28 around the blocks 26 and 27. The teeth should than comprise recesses for fixing the elastic endless bands 29 and 30. The mobile phone 28 could even be fixed by a tape on the blocks 26 and 27 or directly on one side of the second rotation element 22. The fixing recesses 24 and 25 and the teeth 31 and/or the sides of the second rotation element 22 have the same cross-sectional shape along the cylinder axis. However, the cross-sectional shape should be constant for all cross-sections along the cylinder axis for inserting or rotating the second rotation element 22.

The first rotation element 21 holding the second rotation element 22 forming together the holding device can be placed in a support table as support structure similar to the support table 3. Preferably, the opening in the support table for supporting the holding device according to the second embodiment comprises two opposing parallel edges with a smaller distance than the diameter of the cylinder of the first rotation element 21. The opening could be rectangular, wherein the other two sides have a distance allowing every polar angle of the holding device, e.g. the distance of two opposing sides of the second rotation element 22.

The first rotation element 21 could show a scale or parallel lines indicating the polar angles of the holding device. The second rotation element 22 could indicate the actual angle of the second rotation element 22 with respect to the first rotation element 21 by a scale at the edge of the first rotation element 22.

The second embodiment and its alternative embodiments are very advantageous, because the mobile phone 28 held by the second rotation element 22 could be positioned in every polar angle and a number of azimuth angles. In every possible position of the mobile phone 28, the electromagnetic wave from or to the measurement antenna being arranged passes the cylinder surface of the first rotation element 21 in a 90° angle. In addition, the mobile phone 28 is well accessible and changes of the properties of the mobile phone 28 can be realized without removing the mobile phone 28 from the blocks 25 and 26. Properties of the mobile phone 28 are e.g. different modes of use and different mechanical positions of e.g. clamshell mobile phones. The keyboard of the mobile phone 28 is well accessible and all properties of the mobile phone 28 are immediately visible for a user.

In one embodiment, the recesses 4 and 23 are even suitable for holding a mobile phone together with a device simulating a human head as a part of a human body. Alternatively, the holding device shows inhomogeneous relative permittivity for simulating the human head by a holding device itself. Thus, the recesses 4 and 23 can be maintained in the size of the mobile phone 28 or other entities under test.

In another embodiment, the system could comprise also drive means for automatically rotating the spherical holding device around two axis of rotation. Preferably, such a system comprises a holding device 2 as described which is supported by three balls. The three balls are arranged on an imaginary circle, wherein the circle line created by the three points of the three balls supporting the holding device 2 is has a smaller radius than the radius of the spherical holding device 2. The three balls are arranged within an angle of more than 180° to stably support the holding device 2. A first and a second of the three balls are drivable around one axis of rotation, respectively. The first ball is drivable around the first axis of rotation being rectangular to the imaginary circle plane and the second ball is drivable around the second axis of rotation being rectangular to the first axis of rotation such that the plane of rotation passes the centre of the imaginary circle. The first and second balls are arranged at an 90 ° angle with respect to the centre point of the imaginary circle. The third ball is preferably arranged on the other side of the circle between the first and second ball. The third ball is pivotable around every axis of rotation. Consequently, the spherical holding device 2 is pivotable around two axis of rotation without any friction of the support structure. Even the cylinder as holding device as described before can be driven by one ball or wheel around the axis of rotation of the cylinder.

In another embodiment, preferably in combination with the described drive means, the system comprises a position detection device for detecting the orientation of the holding device 2 with respect to the support structure. This can be realized by calculating the actual position by the change of the position caused by the drive means from a start position. The actual orientation of the holding device 2 can even be detected by a light emitting diode (LED) mounted on a reference point of the holding device 2. The position of the holding device 2 could be detected by a camera in the anechoic chamber.

The invention is not restricted to the described embodiments. All described embodiments can be combined advantageously.

## Claims

1. Holding device for positioning a device for wireless communication in a measurement environment, the holding device (2) comprising a holding means (4) for holding the device for wireless communication,
**characterised in that**
an outer surface of the holding device (2) surrounds or mostly surrounds the holding means (4).

2. Holding device according to claim 1,
**characterised in that**
for at least one axis (18) of rotation of the holding device (2) every axis (19) being orthogonal to said axis of rotation is also orthogonal or mostly orthogonal to the outer surface of the holding device (2).

3. Holding device according to claim 1 or 2, **characterised in that**
the holding means (4) is positioned in the centre of the holding device (2).

4. Holding device according to any of claims 1 to 3, **characterised in that**
the holding means (4) is formed by a recess in the holding device (2).

5. Holding device according to claim 4,
**characterised in that**
the longitudinal axis of the recess traverses the centre point of the holding device (2).

6. Holding device according to claim 4 or 5, **characterised in that**
the holding means comprises a cartridge for holding the device for wireless communication and the cartridge is insertable in the recess.

7. Holding device according to any of claims 1 to 6, **characterised in that**
the relative permittivity of the holding device (2) is less than 4.

8. Holding device according to any of claims 1 to 7, **characterised in that**
the holding means (4) is suitable for holding the device for wireless communication together with a simulating device for simulating at least a part of a human body or the holding device (2) has inhomogeneous relative permittivity simulating at least a part of a human body.

9. Holding device according to any of claims 1 to 8, **characterised in that**
the holding device has a spherical shape.

10. Holding device according to claim 9,
**characterised in that**
the holding device (2) comprises two hemispherical parts (11, 12) or two nearly hemispherical parts.

11. Holding device according to claim 10,
**characterised in that**
the holding means (4) is formed by a recess in the holding device (2) and a surface dividing the two hemispherical parts (11, 12) or nearly hemispherical parts traverses the recess.

12. Holding device according to claim 10 or 11, **characterised in that**
the two hemispherical parts (11, 12) or nearly hemispherical parts are joinable by a form-locked joint and are dividable by a sliding movement in one direction within a plane dividing the two hemispherical (11, 12) or nearly hemispherical parts.

13. Holding device according to any of claims 9 to 12, **characterised by**
a number of first type circle-lines (8) on the outer surface, which all intersect in two opposing points and are marked with corresponding azimuth angles and/or a number of second type circle-lines (20) being parallel to each other and marked with corresponding polar angles, wherein the second type circle-lines (20) intersect the first type circle-lines (8) orthogonally, if a number of first type circle-lines (8) and a number of second type circle-lines (20) are signed on the outer surface.

14. Holding device according to any of claims 1 to 8, **characterised in that**
the holding device has a cylindrical shape.

15. Holding device according to claim 14,
**characterised in that**
the holding device comprises a first rotation element (21) having a cylindrical shape and a second rotation element (22) with said holding means (25, 26, 31) being positionable in the first rotating element (21) in at least two positions.

16. System for positioning a device for wireless communication in a measurement environment, the system comprising a holding device (2) and a support structure (3) for positioning the holding device (2)
**characterised in that**
the holding device (2) corresponds to any of claims 1 to 15.

17. System according to claim 16,
**characterised in that**
the support structure (3) comprises an opening (7) for positioning the holding device (2).

18. System according to claim 17,
**characterised in that**
the holding device (2) has a spherical shape according to claims 8 to 12 and the support structure (3) comprises a circular opening (7) with a diameter smaller than the diameter of the spherical holding device (2) for positioning the holding device (2) and the support structure (3) shows at least one mark (9) near the edge of the opening (7).

19. System according to claim 18,
**characterised in that**
the holding device (2) has at least a number of secondary type circle lines (20) according to claim 11 and the polar angles are marked with an off-set at the secondary type circle lines on the outer surface of the holding device (2) such that the actual polar angle of the holding device (2) is readable at the mark (9) at the border of the opening (7) of the support structure, when the holding device (2) is positioned in the opening (7) of the support structure (3).

20. System according to any of claims 16 to 19, **characterised in that**
the holding device (2) is positioned pivotally on the support structure and the support structure comprises driving means for rotating the holding device (2) at least around one axis of rotation.

21. System according to claim 20,
**characterised in that**
the holding device (2) has a spherical shape according to claims 8 to 12 and the support structure comprises three balls arranged on a circle, wherein a first and a second ball for driving the holding device (2) around a first and a second axis of rotation respectively are arranged nearly at an angle of 90° with respect to the centre point of the circle and the third ball being pivotable is arranged between an angle of 90° to 180° from each of the two balls with respect to the centre point of the circle.

## Amended claims

### Amended claims in accordance with Rule 137(2) EPC.

**1.** Holding device for positioning a device for wireless communication in a measurement environment, the holding device (2) comprising a holding means (4) for holding the device for wireless communication, the holding device having an outer surface of the holding device (2) surrounds or mostly surrounds the holding means (4)
**characterised by**
a number of first type circle-lines (8) on the outer surface, which all intersect in two opposing points and are marked with corresponding azimuth angles and/or a number of second type circle-lines (20) being parallel to each other and marked with corresponding polar angles,
wherein the second type circle-lines (20) intersect the first type circle-lines (8) orthogonally, if a number of first type circle-lines (8) and a number of second type circle-lines (20) are signed on the outer surface.

**2.** Holding device according to claim 1,
**characterised in that**
for at least one axis (18) of rotation of the holding device (2) every axis (19) being orthogonal to said axis of rotation is also orthogonal or mostly orthogonal to the outer surface of the holding device (2).

**3.** Holding device according to claim 1 or 2,
**characterised in that**
the holding means (4) is positioned in the centre of the holding device (2).

**4.** Holding device according to any of claims 1 to 3,
**characterised in that**
the holding means (4) is formed by a recess in the holding device (2).

**5.** Holding device according to claim 4,
**characterised in that**
the longitudinal axis of the recess traverses the centre point of the holding device (2).

**6.** Holding device according to claim 4 or 5,
**characterised in that**
the holding means comprises a cartridge for holding the device for wireless communication and the cartridge is insertable in the recess.

**7.** Holding device according to any of claims 1 to 6,
**characterised in that**
the relative permittivity of the holding device (2) is less than 4.

**8.** Holding device according to any of claims 1 to 7,
**characterised in that**
the holding means (4) is suitable for holding the device for wireless communication together with a simulating device for simulating at least a part of a human body or
the holding device (2) has inhomogeneous relative permittivity simulating at least a part of a human body.

**9.** Holding device according to any of claims 1 to 8,
**characterised in that**
the holding device has a spherical shape.

**10.** Holding device according to claim 9,
**characterised in that**
the holding device (2) comprises two hemispherical parts (11, 12) or two nearly hemispherical parts.

**11.** Holding device according to claim 10,
**characterised in that**
the holding means (4) is formed by a recess in the holding device (2) and a surface dividing the two hemispherical parts (11, 12) or nearly hemispherical parts traverses the recess.

**12.** Holding device according to claim 10 or 11,
**characterised in that**
the two hemispherical parts (11, 12) or nearly hemispherical parts are joinable by a form-locked joint and are dividable by a sliding movement in one direction within a plane dividing the two hemispherical (11, 12) or nearly hemispherical parts.

**13.** Holding device for positioning a device for wireless communication in a measurement environment, the holding device (2) comprising a holding means (4) for holding the device for wireless communication, the holding device having an outer surface of the holding device (2) surrounds or mostly surrounds the holding means (4)
**characterised in that**
the holding device has a cylindrical shape and shows a scale or parallel lines indicating the polar angles of the holding device.

**14.** Holding device according to claim 13,
**characterised in that**
the holding device comprises a first rotation element (21) having a cylindrical shape and a second rotation element (22) with said holding means (25, 26, 31) being positionable in the first rotating element (21) in at least two positions.

**15.** System for positioning a device for wireless communication in a measurement environment, the system comprising a holding device (2) and a support structure (3) for positioning the holding device (2)
**characterised in that**
the holding device (2) corresponds to any of claims 1 to 14.

**16.** System according to claim 15,
**characterised in that**
the support structure (3) comprises an opening (7) for positioning the holding device (2).

**17.** System according to claim 16,
**characterised in that**
the holding device (2) has a spherical shape according to claims 8 to 12 and the support structure (3) comprises a circular opening (7) with a diameter smaller than the diameter of the spherical holding device (2) for positioning the holding device (2) and the support structure (3) shows at least one mark (9) near the edge of the opening (7).

**18.** System according to claim 17,
**characterised in that**
the holding device (2) has at least a number of secondary type circle lines (20) according to claim 11 and the polar angles are marked with an off-set at the secondary type circle lines on the outer surface of the holding device (2) such that the actual polar angle of the holding device (2) is readable at the mark (9) at the border of the
opening (7) of the support structure, when the holding device (2) is positioned in the opening (7) of the support structure (3).

**19.** System according to any of claims 15 to 18,
**characterised in that**
the holding device (2) is positioned pivotally on the support structure and the support structure comprises driving means for rotating the holding device (2) at least around one axis of rotation.

**20.** System according to claim 19,
**characterised in that**
the holding device (2) has a spherical shape according to claims 8 to 12 and the support structure comprises three balls arranged on a circle, wherein a first and a second ball for driving the holding device (2) around a first and a second axis of rotation respectively are arranged nearly at an angle of 90° with respect to the centre point of the circle and the third ball being pivotable is arranged between an angle of 90° to 180° from each of the two balls with respect to the centre point of the circle.
